# EUROPEAN PATENT APPLICATION

(11) **EP 1 263 044 A2**
(43) Date of publication of application: **04.12.2002**
(21) Application number: 02253737.7
(22) Date of filing: 28.05.2002
(51) Int. Cl.: H01L 23/552, H01L 23/66

(54) **A cap for reducing cross-talk between devices on a common substrate and a method of manufacture therefor**

(30) Priority: 29.05.2001 US 294066 P
(71) Applicant: Agere Systems Inc., Allentown, PA 18109 (US)
(72) Inventor: Sun, Yangling, De Meern (NL); Tieman, Theo C., Capelle aan der Ijsel (NL)
(74) Representative: Williams, David John

(57) **Abstract**

The present invention provides, in one aspect, a package (340) for reducing cross-talk between devices on a device substrate (330), an integrated device including the package (340), and a method of manufacture therefor. In one embodiment of the invention, the package (340) includes a cap (342) positioned over a first device (310). In such an embodiment, the cap (342) is configured to separate the first device (310) and a second device (320) and to substantially reduce cross-talk there between. The package (340) may further include a layer of barrier material (349) located on a surface of the cap (342).

## Description

### CROSS-REFERENCE TO PROVISIONAL APPLICATION

This application claims the benefit of U.S. Provisional Application No.60,294,066 entitled "ON-WAFER MICROMACHINED SILICON PACKAGE," to Yanling Sun, filed on May 29, 2001, which is commonly assigned with the present invention and incorporated herein by reference as if reproduced herein in its entirety.

### TECHNICAL FIELD OF THE INVENTION

The present invention is directed, in general, to packaging technology and, more specifically, to a package for reducing cross-talk between devices on a device substrate and a method of manufacture therefor.

### BACKGROUND OF THE INVENTION

The integration of multiple devices on a single substrate is gaining increasing interest in the communications industry. Of particular interest, is the integration of multiple devices associated with a wireless local area network (LAN). For example, recently there are more and more radio frequency (RF) transceivers for wireless communication systems integrated with voltage-controlled oscillators (VCOs), phase-lock loop (PLL) devices, and power amplifiers (PAs) on a single substrate. There is additional interest in system-on-chip (SOC) solutions that include complete RF transceiver, base-band digital-signal-processor (DSP) blocks and medium-access-control (MAC) blocks on a single substrate.

A problem arises, however, that these integrated systems or sub-systems suffer from interference associated with RF signal devices proximate other RF signal devices, as well as other digital signal devices. Generally, the interference is caused by cross-talk between the various devices. As is well known, cross-talk results when electrical noise, which is often a product of the higher current levels associated with RF devices, travels through the capacitive coupling of the device substrate and surrounding materials (e.g., air or dielectric material) and negatively affects the performance of other devices located nearby.

The communications industry has attempted to reduce this cross-talk by using silicon bulk etch under certain ones of the devices. The industry has also attempted to use silicon-on-insulator (SOI) as a barrier to the potentially detrimental cross-talk. While these two steps have been of particular benefit in reducing cross-talk through the device substrate, they often fail to reduce the amount of cross-talk that occurs through the surrounding materials.

Accordingly, what is needed in the art is a package for reducing cross-talk between devices on a device substrate, and a method of manufacture therefor.

### SUMMARY OF THE INVENTION

To address the above-discussed deficiencies of the prior art, the present invention provides a package for reducing cross-talk between devices on a device substrate, an integrated device including the package, and a method of manufacture therefor. In one embodiment of the invention, the package includes a cap positioned over a first device. In such an embodiment, the cap is configured to separate the first device and a second device and to substantially reduce cross-talk there between. The package may further include a layer of barrier material located on a surface of the cap.

In an alternative embodiment, the present invention provides an integrated device. The integrated device includes first and second devices located on a device substrate, with a cap positioned over the first device. In such an embodiment, the cap separates the first and second devices. The integrated device further includes a layer of barrier material located on a surface of the cap.

The foregoing has outlined preferred and alternative features of the present invention so that those skilled in the art may better understand the detailed description of the invention that follows. Additional features of the invention will be described hereinafter that form the subject of the claims of the invention. Those skilled in the art should appreciate that they can readily use the disclosed conception and specific embodiment as a basis for designing or modifying other structures for carrying out the same purposes of the present invention. Those skilled in the art should also realize that such equivalent constructions do not depart from the spirit and scope of the invention.

### BRIEF DESCRIPTION OF THE DRAWINGS

The invention is best understood from the following detailed description when read with the accompanying FIGURES. It is emphasized that in accordance with the standard practice in the microelectronics industry, various features are not drawn to scale. In fact, the dimensions of the various features may be arbitrarily increased or reduced for clarity of discussion. Reference is now made to the following descriptions taken in conjunction with the accompanying drawings, in which:
FIGURE 1 illustrates a cross-sectional view of one embodiment of an integrated device, constructed according to the principles of the present invention;
FIGURE 2 illustrates a cross-sectional view of another embodiment of an integrated device, constructed according to the principles of the present invention; and
FIGURE 3 illustrates a cross-sectional view of another embodiment of an integrated device, constructed according to the principles of the present invention.

### DETAILED DESCRIPTION

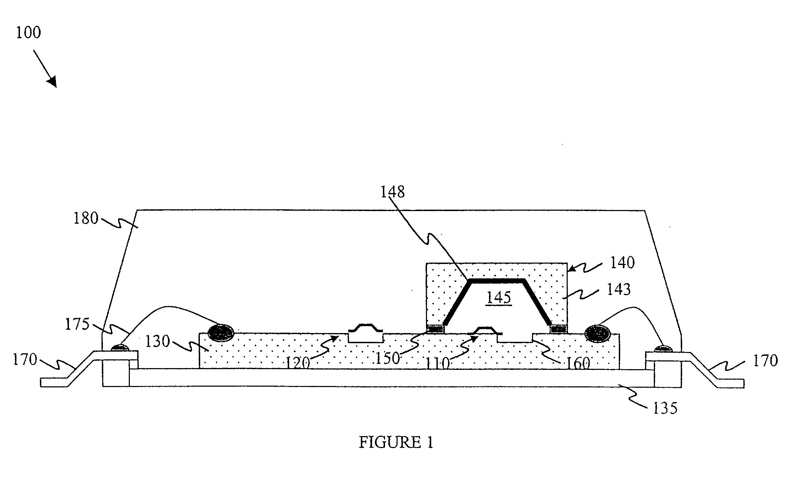

Referring initially to FIGURE 1, illustrated is a cross-sectional view of one embodiment of an integrated device 100, constructed according to the principles of the present invention. In the particular embodiment shown in FIGURE 1, the integrated device 100 includes a first device 110 and a second device 120 located on a device substrate 130. The device substrate 130 may be any layer located in a microelectronic device, including a layer located at the wafer level or a layer located above wafer level. For example, as illustrated, the device substrate 130 may be located on a base plate 135.

In the illustrative embodiment of FIGURE 1, the first device 110 is a radio frequency (RF) signal device and the second device 120 is a digital signal device. While the present embodiment describes using an RF signal device for the first device 110 and a digital signal device for the second device 120, other devices are also within the scope of the present invention. As an example, each of the first or second devices 110, 120 may be a voltage-controlled oscillator (VCO), a phase-locked loop (PLL) device, a power amplifier (PA), a digital signal processor (DSP), a RF transceiver, a medium-access-controller (MAC), a micro-electro-mechanical system (MEMS) device, or another similar device. One skilled in the art should understand that the herein described devices may be formed by a single or multiple components, circuits, systems or sub-systems.

Positioned over the first device 110 is a package 140. As illustrated, the package 140 may comprise a cap 143 having a cavity 145 located therein. One skilled in the art understands that the cap 143 may comprise various conventional materials. In one particular embodiment of the present invention, the cap 143 comprises the same material as the device substrate 130. For example, silicon is particularly useful for both the device substrate 130 and the cap 143. It should be noted, however, that any other known or hereafter discovered material may be used for the cap 143.

While it has been illustrated that the cap 143 may comprise a substrate having a cavity 145 located therein, other cap structures are within the scope of the present invention. For example, in an alternative embodiment (not shown), the cap 143 could comprise various individual structures (e.g., sidewall structures and a top structure) that cooperate to form the cap 143. In a different embodiment (not shown), the first device 110 may be formed in a trench structure in the device substrate 130, and the cap 143 comprises a single top structure positioned over the first device 110 and the trench structure. Accordingly, as established, the cap 143 may comprise a variety of structures.

As previously described in the embodiment above, a cavity 145 is located within the cap 143. The cavity 145 may take on various shapes and sizes. The cavity 145 should, however, be of sufficient size and shape to allow the first device 110 to operate in its intended manner. If the cavity 145 is too small, it may impede the function of the first device 110.

In general, one skilled in the art understands how-to form the cavity 145 within the cap 143. In one particular embodiment, a bulk piece of insulative material having a given thickness is cleaved to a desired length and width. The insulative material may comprise any material that physically or electrically protects the first and second devices 110, 120, and is within the scope of the present invention. The cleaved insulative material may then be subjected to a conventional etch known to form cavities or trenches, such as the cavity 145. In the illustrative embodiment shown in FIGURE 1, the cavity 145 was formed using a bulk etch of the cleaved material, for example, using a potassium hydroxide (KOH) solvent. While one particular conventional method for forming the cavity 145 has been described, those skilled in the art understand that many other conventional processes may be used.

The package 140 further includes a layer of barrier material 148 located on a surface of the cap 143. The layer of barrier material 148 is configured to reduce the amount of cross-talk occurring between the first and second devices 110, 120. In an alternative embodiment, the layer of barrier material 148 is configured to reduce the amount of cross-talk occurring between the first device 110 and any other device within the integrated device 100. In the particular embodiment shown, the layer of barrier material 148 is located on a surface of the cavity 145, however, those skilled in the art understand the layer of barrier material 148 may also be located on any other surface of the cap 143, including the outer surface.

The layer of barrier material 148 may comprise a multitude of different materials while staying within the scope of the present invention. It has been determined that conductive materials, such as those comprising metal, are particularly beneficial for use as the layer of barrier material 148. For example, in one particularly useful embodiment, the layer of barrier material 148 comprises at least one of aluminum, copper, gold, silver, platinum and any alloys or combinations thereof. Also of particular importance for the layer of barrier material 148, are conductively doped semiconductor materials, an electromagnetic absorptive material, or another similar.

While various types of materials have been given for the layer of barrier material 148, each are conventionally formed, and therefore, require no additional discussion as to their manufacture. The thickness of the layer of barrier material 148 may vary greatly. For example, in one particular embodiment the thickness of the layer of barrier material 148 ranges from about .01 µm to about 10 µm, and even more specifically, from about .1 µm to about 2 µm.

In the illustrative embodiment shown, fastening structures (one of which is designated 150) may be used to couple the package 140 to the device substrate 130. While many different types and styles of fastening structures may be used, solder bumps or other similar structures are particularly useful. If used, the solder bumps function in a similar manner as the barrier material 148, in that they may also reduce the aforementioned cross-talk.

Further, the fastening structures 150, in combination with the package 140, may be used to maintain the cavity 145 at a substantial vacuum. It has been determined that the vacuum is very beneficial in that it substantially protects the first device 110 from extrinsic factors.

Subsequent to placing the package 140 over the first device 110, conventional packaging procedures may be used to complete the device. For example, the device substrate 130 may be connected to the base plate 135, and conventional pins 170 and bond wires (one of which is designated 175) may be connected to the first and second devices 110, 120.

After completion of the conventional pins 170 and bond wires 175, as well as any other structural devices, an enclosure 180 may then be formed over the integrated device 100. In the particular embodiment shown, the enclosure 180 comprises a hermetic material that encapsulates the integrated device 100. The hermetic enclosure advantageously isolates the first and second devices 110, 120 from environmental contaminants (e.g., moisture) and damage that might harm their operation. Beyond just providing hermeticity, the enclosure 180 is configured to protect the integrated device 100 from common mechanical bumps or stresses.

In an exemplary embodiment of the present invention, the enclosure 180 comprises a standard plastic package having a thickness sufficient to protect the package 140 from any subsequent processing steps. This thickness varies from device to device and application to application. Accordingly, no specific range of thicknesses exists.

The present invention benefits from the use of the aforementioned package 140, and more specifically, the use of the layer of barrier material 148. For example, in an exemplary embodiment of the present invention, the package 140 substantially reduces the amount of cross-talk that occurs between the first device 110 and any other device of the integrated device 100. Of noted importance, is the decrease in the amount of cross-talk that occurs through the materials located over the device substrate 130 (e.g., air or dielectric material) while using the package 140. In addition to the package 140 reducing cross-talk through the materials located over the device substrate 130, trenches (one of which is designated 160) may be formed in the device substrate 130 and under or surrounding the first or second devices 110, 120, to further reduce any cross-talk that may occur through the device substrate 130 itself. Accordingly, in one embodiment, the present invention provides an integrated device 100 that substantially decreases cross-talk through both the device substrate 130 and through the materials located over the device substrate 130 (e.g., air or dielectric material).

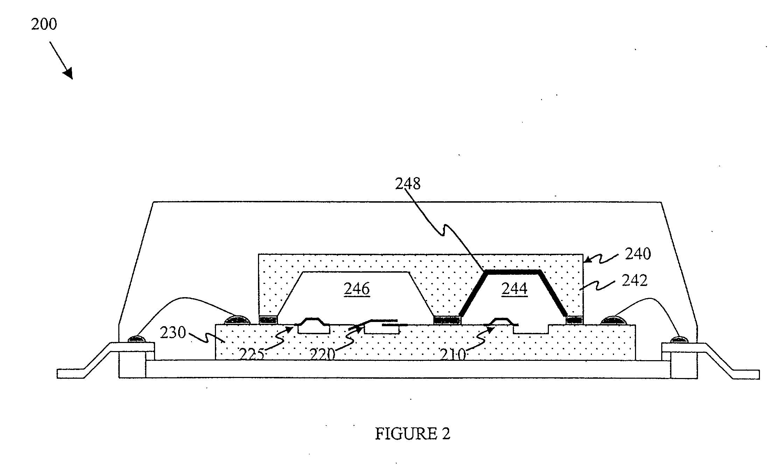

Turning now to FIGURE 2, illustrated is a cross-sectional view of another embodiment of an integrated device 200, constructed according to the principles of the present invention. The integrated device 200 of FIGURE 2, similar to that of FIGURE 1, includes first and second devices 210, 220 located on a device substrate 230.

Positioned over the first and second devices 210, 220 is a package 240. As illustrated, the package 240 comprises a cap 242 having a first cavity 244 and second cavity 246 located therein. In the illustrative embodiment shown, the first and second cavities 244, 246 separate the first and second devices 210, 220. It should be noted, as shown, that another device 225 may be located proximate the second device 220. Similar to the embodiment of FIGURE 1, a layer of barrier material 248 may be located on a surface of the first cavity 244. As discussed above, the layer of barrier material 248 is configured to reduce the amount of cross-talk occurring between the first and second devices 210, 220.

In the illustrative embodiment shown, the integrated device 200 includes the other device 225, which is located proximate the second device 220 and under the second cavity 246. The embodiment shown is particularly useful. For example, if the second device 220 were an RF MEMS device, the second cavity 246 could protect it from subsequent processing conditions, while the barrier material 248 reduces interference between the first device 210 and the other devices 220, 225.

Except for the cap 242 including first and second cavities 244, 246, the cap 242 of FIGURE 2 is similar to the cap 143 of FIGURE 1. Accordingly, no discussion is forthcoming as to its composition, size, shape or method of manufacture. After completion of the package 240, the integrated device 200 would continue to be manufactured according to the process set forth above with respect to

### FIGURE 1.

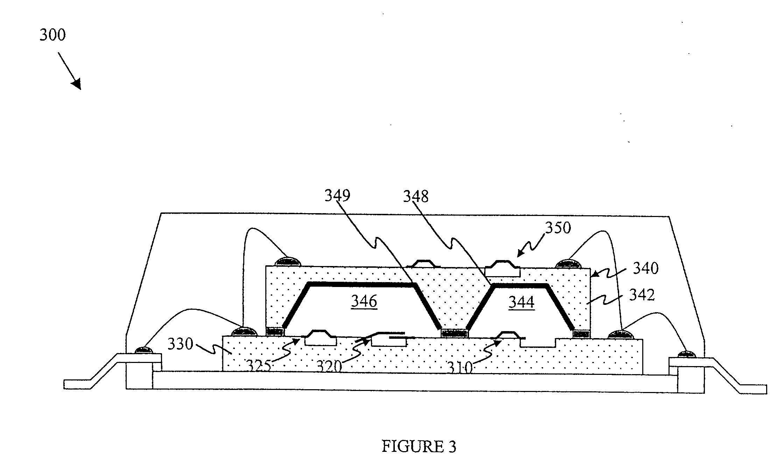

Turning now to FIGURE 3, illustrated is a cross-sectional view of another embodiment of an integrated device 300, constructed according to the principles of the present invention. The integrated device 300 of FIGURE 3 includes first and second devices 310, 320 formed on a device substrate 330. The integrated device 300 further includes a package 340 comprising a cap 342 having first and second cavities 344, 346 formed therein.

The package 340 of FIGURE 3 is similar to the package 240 shown in FIGURE 2, except that a second layer of barrier material 349 may be formed on a surface of the second cavity 346. The second layer of barrier material 349 may comprise a material similar to or different from the material forming the first layer of barrier material 348. If the first and second layers of barrier material 348, 349 comprise the same material, they may easily be formed in a single manufacturing step.

As further illustrated in FIGURE 3, the cap 342 includes a lower surface and an upper surface. In the illustrative embodiment shown, a third device 350 is formed on the upper surface of the cap 342. By forming the third device 350 on the upper surface of the cap 342, a large amount of area may be saved on the device substrate 330. Of note, the first and second layers of barrier material 348, 349 substantially reduce any cross-talk that might occur between the first and second devices 310, 320 and the third device 350.

The third device 350, similar to the first and second devices 310, 320 may be a variety of different devices. For instance, among others, the third device 350 may comprise a voltage-controlled oscillator (VCO), a phase-locked loop (PLL) device, a power amplifier (PA), a digital signal processor (DSP), a radio frequency (RF) transceiver, a medium-access-controller (MAC), a micro-electro-mechanical system (MEMS) device, or another similar device. Generally, however, the third device 350 is not protected by a package, thus it should be chosen to be a device that is insensitive to cross-talk created by any other interference source, e.g., from a nearby wireless user or even from the first or second devices 310, 320.

While only two main devices were described with respect to FIGURES 1 & 2, and only three main devices were described with respect to FIGURE 3, one skilled in the art understands that any number of devices may be included within the embodiments shown in FIGURES 1-3. For example, more than two devices could be located on the device substrate, as well as more than one device could be located on the upper surface of the cap. Additionally, those skilled in the art understand that other levels (e.g., third level, fourth level, etc.) of devices could be formed over the third device (FIGURE 3), using the same principles taught in FIGURE 3.

Although the present invention has been described in detail, those skilled in the art should understand that they can make various changes, substitutions and alterations herein without departing from the spirit and scope of the invention in its broadest form.

## Claims

1. A package for reducing cross-talk between devices on a device substrate, comprising:
a cap configured to be positioned over a first device, wherein the cap is also configured to separate the first device and a second device; and
a layer of barrier material located on a surface of the cap and configured to substantially reduce cross-talk between the first and second devices.

2. The package as recited in Claim 1 wherein the cap includes a cavity, wherein the cavity is configured to separate the first device and the second device.

3. The package as recited in Claim 2 wherein the layer of barrier material is located on a surface of the cavity.

4. The package as recited in Claim 3 wherein the cavity is a first cavity and the cap further includes a second cavity configured to be positioned over the second device.

5. The package as recited in Claim 1 wherein the layer of barrier material comprises a conductive material selected from the group of materials consisting of:
aluminum;
copper;
gold;
silver; and
platinum.

6. The package as recited in Claim 1 wherein the layer of barrier material comprises a conductive semiconductor material or an electromagnetic absorptive material.

7. An integrated device, comprising:
first and second devices located on a device substrate;
a cap positioned over the first device, wherein the cap separates the first and second devices; and
a layer of barrier material located on a surface of the cap.

8. The integrated device as recited in Claim 7 wherein the cap includes a cavity, wherein the cavity separates the first device and the second device.

9. The integrated device as recited in Claim 8 wherein the layer of barrier material is located on a surface of the cavity.

10. The integrated device as recited in Claim 9 wherein the cavity is a first cavity and the cap further includes a second cavity positioned over the second device.

11. The integrated device as recited in Claim 10 wherein the layer of barrier material is a first layer of barrier material, and further including a second layer of barrier material located on a surface of the second cavity.

12. The integrated device as recited in Claim 11 wherein the first and second cavities are located within a lower surface of the cap, and further including a third device located on an upper surface of the cap.

13. The integrated device as recited in Claim 12 wherein the third device is insensitive to cross-talk created by the first or second devices.

14. The integrated device as recited in Claim 8 wherein the cavity is maintained at a substantial vacuum.

15. The integrated device as recited in Claim 7 further including a hermetic material encapsulating the cap and first and second devices.

16. The integrated device as recited in Claim 7 wherein the cap and device substrate comprise silicon.

17. The integrated device as recited in Claim 7 wherein the layer of barrier material comprises a conductive material selected from the group of materials consisting of:
aluminum;
copper;
gold;
silver; and
platinum.

18. The integrated device as recited in Claim 7 wherein the layer of barrier material comprises a conductive semiconductor material or an electromagnetic absorptive material.

19. The integrated device as recited in Claim 7 wherein the layer of barrier material has a thickness ranging from about .1 µm to about 2 µm.

20. The integrated device as recited in Claim 7 wherein the first device is a radio frequency (RF) signal device and the second device is a digital signal device, and the layer of barrier material reduces the effect interference from the second device has on the first device.

21. The integrated device as recited in Claim 7 further including a trench located in the device substrate and proximate at least one of the first or second devices.

22. A method of manufacturing an integrated device, comprising:
creating first and second devices on a device substrate;
positioning a cap over the first device, wherein the cap separates the first and second devices; and
forming a layer of barrier material on a surface of the cap.

23. The method as recited in Claim 22 wherein positioning a cap includes positioning a cap having a cavity located therein over the first device, wherein the cavity separates the first and second devices.

24. The method as recited in Claim 23 wherein forming a layer includes forming a layer of barrier material on a surface of the cavity.

25. The method as recited in Claim 24 wherein the cavity is a first cavity and the cap further includes a second cavity located over the second device.

26. The method as recited in Claim 25 wherein forming a layer of barrier material on a surface of the cavity includes forming a first layer of barrier material on a surface of the first cavity, and further including forming a second layer of barrier material on a surface of the second cavity.

27. The method as recited in Claim 26 wherein the first and second cavities are located within a lower surface of the cap, and further including creating a third device on an upper surface of the cap.

28. The method as recited in Claim 22 further comprising encapsulating the cap and first and second devices with a hermetic material.
